# FASCICULE DE BREVET EUROPEEN

(11) **EP 2 882 094 B1**
(45) Date de publication et mention de la délivrance du brevet: **31.07.2019**
(21) Numéro de dépôt: 14193201.2
(22) Date de dépôt: 14.11.2014
(51) Int. Cl.: H02P 29/02, B62D 5/04, H02H 7/08

(54) **Procédé d'évacuation de l'énergie stockée dans un stator d'un moteur électrique**
Verfahren zum Ableiten der in einem Stator eines Elektromotors gespeicherten Energie
Method for discharging energy stored in a stator of an electric motor

(30) Priorité: 14.11.2013 FR 1361098
(43) Date de publication de la demande: 10.06.2015
(73) Titulaire: Valeo Systèmes de Contrôle Moteur, 95800 Cergy (FR)
(72) Inventeur: Bertrand, Mathieu, 93100 MONTREUIL (FR); Raynal, Ludovic, 92250 La Garenne Colombes (FR); Plaideau, Michel, 95590 Presles (FR)
(74) Mandataire: Mozelle, Gérard Jacques

(56) Documents cités:
- DE-A1-102012 101 127
- DE-A1-102012 208 632
- FR-A1- 2 872 770
- US-A1- 2008 265 818
- US-A1- 2013 113 405

## Description

L'invention se rapporte à un procédé d'évacuation de l'énergie stockée dans un stator d'un moteur électrique, notamment d'un moteur électrique de direction assistée d'un véhicule automobile ainsi qu'à un dispositif d'évacuation de l'énergie stockée dans un stator d'un moteur électrique.

De plus en plus de véhicules automobiles sont équipés d'un dispositif de direction assistée électrique. Les dispositifs de direction assistée électrique utilisent un moteur électrique polyphasé pour aider le conducteur à orienter les roues du véhicule.

Pour des raisons de sécurité, il est important de pouvoir déconnecter les phases du moteur électrique du dispositif de commande du moteur en cas de disfonctionnement du dispositif de direction assistée. En effet, sans cela, il y a un risque de blocage des roues du véhicule en cas de disfonctionnement. Il est connu d'utiliser des relais électriques d'ouverture de phase afin de permettre l'ouverture des phases du moteur électrique de direction assistée électrique en cas de disfonctionnement.

Le document US 2013/113405 A1 décrit par ailleurs un procédé de déconnexion des phases d'un moteur électrique d'un système de direction assistée.

Cette déconnexion des phases du moteur peut intervenir avec un courant dans les phases du moteur relativement important pouvant aller jusqu'à 160A. De par la nature inductive des phases du moteur, l'énergie emmagasinée dans lesdites phases est proportionnelle au carré de l'intensité du courant.

Lors de la déconnexion des phases du moteur, l'élément générant cette déconnexion évacue l'énergie emmagasinée dans les phases du moteur électrique. Ainsi, les dispositifs interrupteurs permettant de contrôler l'état d'ouverture des phases doivent être dimensionnés pour permettre de dissiper sous forme calorifique l'énergie pouvant être emmagasinée dans les phases du moteur. Un tel dimensionnement pose un problème d'encombrement au niveau du moteur électrique ou de l'électronique de commande du moteur suivant que les interrupteurs sont compris dans le moteur ou dans l'électronique de commande.

Une solution à ce problème de dimensionnement consiste à ne déconnecter les phases du moteur que lorsque l'intensité du courant dans lesdites phases est inférieure à un courant seuil prédéterminé Ib. Le courant seuil correspond à une énergie pouvant être dissipée par les dispositifs interrupteurs sans risque de surchauffe, typiquement égale à 100A.

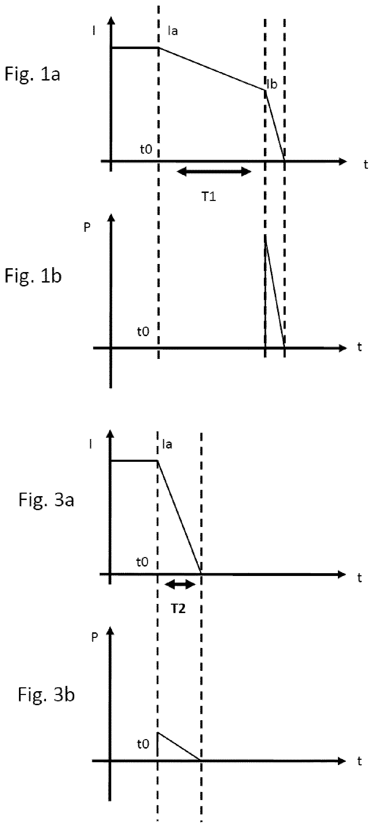

Cette solution est illustrée sur les graphiques représentés aux figures 1a et 1b.

La figure la représente l'évolution du courant dans les phases en fonction du temps. La figure 1b représente la puissance dissipée par les dispositifs interrupteurs en fonction du temps.

Comme illustré sur les figure la, lorsque au temps t0 un signal d'ouverture des interrupteurs est reçu, le courant circulant dans les phases du moteur décroît de sa valeur initial la jusqu'à la valeur seuil prédéterminée Ib. Lorsque le courant circulant dans les phases du moteur atteint la valeur seuil Ib, les dispositifs interrupteurs sont ouverts. Comme illustré sur la figure 1b lors de l'ouverture du dispositif interrupteur l'énergie restant dans les phases du moteur est alors dissipée en une fois.

Ce type de solution nécessite d'avoir un dispositif de supervision du courant circulant dans les phases du moteur. Ce dispositif entraîne un surcoût et peut être sujet à des défaillances. En particulier, lors de la dissipation de l'énergie la température du dispositif interrupteur augmente fortement pouvant entraîner la détérioration desdits dispositifs.

Ainsi, il existe un besoin pour une solution permettant de réduire l'encombrement et d'augmenter la fiabilité de l'ouverture des dispositifs interrupteurs permettant la déconnexion des phases du moteur électrique de direction assistée électrique, qui soit en outre économique.

L'invention a pour but, entre autres, de répondre à ce besoin et y parvient au moyen d'un procédé d'évacuation de l'énergie stockée dans un stator d'un moteur électrique, selon la revendication 1.

En particulier, le maintien du transistor à effet de champ en mode linéaire comprend le contrôle de la tension Vgs entre la grille et la source dudit transistor à effet de champ en fonction de la différence entre la tension de référence Vref et la tension Vds entre le drain et la source dudit transistor à effet de champ. Avantageusement, le procédé selon l'invention permet de maintenir le transistor à effet de champ en mode linéaire empêchant ainsi le transistor de se mettre en mode avalanche.

L'énergie stockée dans le stator du moteur électrique est dissipée plus lentement que lorsque le transistor passe en mode avalanche permettant ainsi une évacuation plus douce de l'énergie. L'énergie se dissipant sous forme calorifique le procédé selon l'invention permet de limiter la montée en température du transistor à effet de champ. Ainsi, l'évacuation de l'énergie stockée dans le moteur selon le procédé de l'invention permet l'utilisation de transistor de surfaces plus petites, réduisant ainsi l'encombrement des dispositifs interrupteurs utilisés.

En outre, le procédé selon l'invention ne requière pas de mesure du courant dans les phases du moteur comme le procédé selon l'art antérieur.

De plus, le procédé selon l'invention peut être mis en oeuvre par un dispositif autonome, i.e. indépendant des alimentations du véhicule et des systèmes de contrôles, permettant la dissipation d'énergie tout en la rendant totalement indépendante d'un circuit de contrôle externe audit dispositif.

Le procédé selon l'invention peut également comprendre une ou plusieurs des caractéristiques ci-dessous, considérées individuellement ou selon toutes les combinaisons techniquement possibles :
- le transistor à effet de champ est de type MOSFET ;
- le moteur électrique est un moteur polyphasé, notamment un moteur triphasé, l'état de déconnexion des phases étant contrôlé par des dispositifs interrupteurs respectifs; et/ou
- la tension de référence Vref est inférieure à la tension d'avalanche du transistor à effet de champ ; et/ou
- le transistor à effet de champ est maintenu en mode linéaire jusqu'à l'évacuation de l'énergie stockée dans le stator ; et/ou
- le procédé comprenant préalablement à l'étape de maintien a) du transistor à effet de champ en mode linéaire, une étape a0) de réception d'un signal d'ouverture de phase initiant le procédé d'évacuation de l'énergie ; et/ou
- l'étape de maintien a) succède immédiatement à l'étape a0) de réception d'un signal d'ouverture de phase.

L'invention concerne également un dispositif d'évacuation de l'énergie stockée dans un stator d'un moteur électrique notamment d'un moteur électrique de direction assistée d'un véhicule automobile selon la revendication 7

En particulier, le circuit de commande est configuré pour contrôler la tension Vgs entre la grille et la source dudit transistor à effet de champ en fonction de la différence entre la tension de référence Vref et la tension Vds entre le drain et la source dudit transistor à effet de champ.

Le dispositif selon l'invention peut également comprendre une ou plusieurs des caractéristiques ci-dessous, considérées individuellement ou selon toutes les combinaisons techniquement possibles :
- le dispositif comprend une alimentation électrique autonome alimentant au moins le circuit de commande ;
- le circuit de commande comprend un régulateur de tension dont :
   - la borne de référence est reliée au drain dudit transistor à effet de champ,
   - l'anode est reliée à la source dudit transistor à effet de champ, et
   - la cathode est reliée à la grille du transistor à effet de champ ; et/ou
- la cathode du régulateur de tension est reliée à la grille du transistor à effet de champ via un transistor bipolaire, la base dudit transistor bipolaire étant reliée à la cathode du régulateur de tension, et le collecteur dudit transistor bipolaire étant relié à la grille dudit transistor à effet de champ ; en particulier l'émetteur dudit transistor bipolaire est relié à l'alimentation électrique autonome ; et/ou
- le régulateur de tension est de type TL431; et/ou
- le dispositif comprend un organe de réception d'un signal d'ouverture de phase.

L'invention sera mieux comprise à la lecture de la description qui va suivre donnée à titre d'exemple non limitatif de mise en oeuvre de celle-ci, et à l'examen du dessin annexé sur lequel :
- les figures 1a et 1b illustrent l'évacuation de l'énergie stockée dans le stator d'un moteur électrique selon un procédé de l'art antérieur,
- la figure 2 représente une première configuration de moteur électrique et d'un dispositif permettant la mise oeuvre d'un procédé selon l'invention,
- les figures 3a et 3b illustrent l'évacuation de l'énergie stockée dans le stator d'un moteur électrique selon un procédé selon l'invention,
- la figure 4 illustre un dispositif d'évacuation d'énergie selon un mode de réalisation de l'invention,
- la figure 5 illustre un dispositif d'évacuation d'énergie selon un autre mode de réalisation de l'invention,
- la figure 6 illustre un dispositif d'évacuation d'énergie selon encore un autre mode de réalisation de l'invention, et
- la figure 7 représente une configuration de moteur électrique et d'un dispositif permettant la mise oeuvre du procédé selon l'invention.

Selon un premier mode de réalisation, le procédé de l'invention permet d'évacuer de l'énergie stockée dans le stator d'un moteur électrique, notamment d'un moteur électrique de direction assistée d'un véhicule automobile.

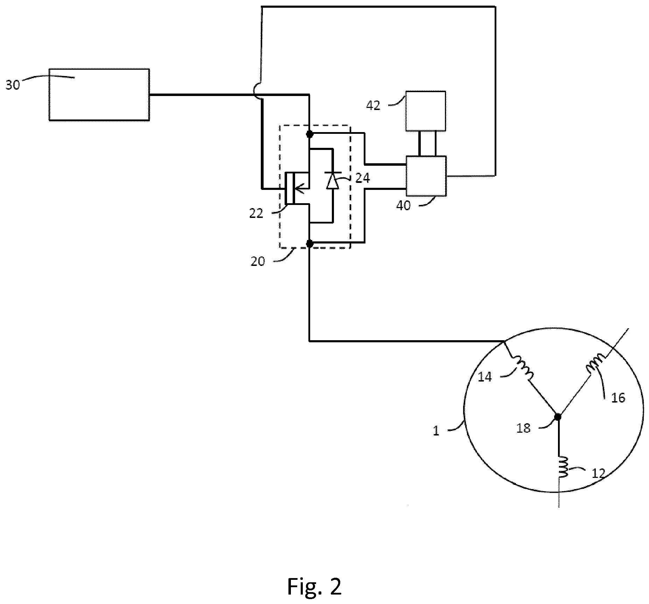

Comme représenté à la figure 2, un moteur électrique de direction assistée peut être polyphasé, notamment triphasé, et comprendre un stator 1. Dans l'exemple de la figure 2, le stator 1 comprend trois phases électriques 12, 14, 16 connectées en étoile. Les phases sont en particulier définies par un enroulement électrique, par exemple au moyen de bobines électriques. Les trois phases électriques 12, 14, 16 sont reliées à un neutre commun 18.

Un dispositif interrupteur 20 fait la connexion électrique entre une phase 14 du stator 1 et un dispositif de commande 30. Le dispositif interrupteur 20 a une borne reliée au dispositif de commande 30 et une autre reliée à la phase 14. Le dispositif de commande 30 peut comprendre entre autres un dispositif de conversion d'énergie, tel qu'un onduleur, et une unité de commande de ce dispositif de conversion. Le dispositif de commande 30 permet d'alimenter le moteur, en particulier le stator 1, à partir d'une source d'énergie (non représentée) telle qu'une batterie.

L'état de déconnexion de chacune des phases électriques 12, 14, 16 d'avec le dispositif de commande 30 est contrôlé par un dispositif interrupteur 20 respectif. Pour des raisons de clarté un seul dispositif interrupteur 20 est représenté sur la figure 2.

Le dispositif interrupteur contrôle le passage d'un courant entre deux bornes grâce à une troisième borne, dite « borne de commande ». En particulier, le dispositif interrupteur 20 comprend un transistor à effet de champ, notamment de type MOSFET 22, avec une diode 24 entre le drain et la source du transistor. La diode 24 est en pratique intrinsèque au transistor à effet de champ 22. La grille du transistor 22 correspond à l'électrode de commande du dispositif interrupteur 20. L'anode de la diode 24 est connectée à une borne de la phase 14, en particulier la borne qui est différente de celle reliée au neutre 18 ; et à une borne du transistor 22, en particulier la source du transistor à effet de champ 22.

L'état d'ouverture du dispositif interrupteur 20 est contrôlé par un circuit de commande 40. Le circuit de commande 40 est alimenté par une alimentation électrique autonome 42. Dans le mode de réalisation illustré en figure 2, chaque dispositif interrupteur 20 est de préférence commandé par un circuit de commande 40 et une alimentation électrique autonome 42 respectifs.

Le circuit de commande 40, avec en particulier l'alimentation électrique autonome 42, permet la mise en oeuvre du procédé d'évacuation d'énergie selon l'invention, qui comprend le maintien du transistor 22 en mode linéaire.

Comme expliqué précédemment, pour des raisons de sécurité, en cas de défaut de la commande du moteur, il est préférable de déconnecter les phases 12, 14, 16 du dispositif de commande 30 afin de laisser le rotor du moteur libre en rotation. L'ouverture des dispositifs interrupteurs 20, 21, 23 peut nécessiter l'évacuation d'une quantité relativement importante d'énergie en fonction de l'intensité du courant présent dans les phases 12, 14, 16 avant la déconnexion.

Le procédé selon l'invention permet d'évacuer l'énergie stockée dans les phases du stator en maintenant le transistor 22 en mode linéaire. Le procédé d'évacuation de l'énergie stockée dans le stator comprend donc une étape de maintien du transistor à effet de champ 22 en mode linéaire.

Le procédé selon l'invention est illustré sur les graphiques représentés aux figures 3a et 3b.

La figure 3a représente l'évolution du courant dans une phase 12, 14, 16 en fonction du temps. La figure 3b représente la puissance dissipée par un dispositif interrupteur 20, 21, 23 en fonction du temps.

Lors de la détection d'une défaillance, telle qu'un défaut de commande ou de fonctionnement de la direction assistée par exemple, le dispositif d'évacuation d'énergie reçoit un signal de déconnexion de phase. Le signal de déconnexion de phase peut par exemple provenir de l'unité de commande du dispositif de commande 30. L'émission de ce signal de déconnexion peut s'accompagner d'une interruption de l'alimentation en énergie du moteur.

Dans l'art antérieur, en l'absence du circuit de commande 40, le dispositif interrupteur 20 est ouvert. La tension entre le drain et la source du transistor 22 monte alors jusqu'à atteindre la tension d'avalanche du transistor. L'expression « tension d'avalanche » signifie que le transistor a une propriété d'avalanche. Autrement dit, lorsque la tension entre les deux bornes du transistor - en particulier entre le drain et la source -, devient supérieure ou égale à une tension seuil, dite « tension d'avalanche », le transistor peut laisser passer un fort courant entre ses deux bornes, qui peut engendrer sa destruction, et ceci bien que sa borne de commande n'ait pas reçu un signal de fermeture de l'interrupteur.

Selon le procédé de l'invention, le transistor à effet de champ 22 est maintenu en mode linéaire grâce au circuit de commande 40 qui contrôle la tension Vgs entre la grille et la source du transistor 22 de sorte à maintenir la tension Vds entre le drain et la source dudit transistor 22 sensiblement égale à une tension de référence Vref. La tension de référence Vref étant inférieure à la tension d'avalanche du transistor à effet de champ 22, le maintien de la tension Vds sous la tension de référence permet d'éviter que le transistor ne passe en mode avalanche.

Typiquement, pour un transistor à effet de champ dont la tension drain-source nominale de fonctionnement est de l'ordre de 30V, la tension d'avalanche est de l'ordre de 40 V et pour un transistor à effet de champ dont la tension drain-source nominale de fonctionnement est de l'ordre de 40 V, la tension d'avalanche est de l'ordre de 50V.

Selon un mode de réalisation, la tension de référence est de l'ordre de 2,5 Volts.

De préférence le transistor 22 est maintenu en mode linéaire jusqu'à l'évacuation de l'énergie stockée dans le stator. Typiquement, le transistor 22 est maintenu en mode linéaire pendant un temps T2 déterminé par la tension de référence. Plus la tension de référence est élevée, plus le temps T2 en mode linéaire est faible. Typiquement le temps T2 est de l'ordre de quelque ms, par exemple supérieur ou égal à 3 ms et/ou inférieur ou égal à 100ms.

Avantageusement, l'évacuation de l'énergie stockée dans le stator du moteur est plus lente lorsque le transistor 22 est maintenu en mode linéaire que lorsque le transistor passe en mode avalanche. Typiquement, l'énergie est évacuée en environ 100 µs lorsque le transistor passe en mode avalanche alors qu'elle s'évacue en plusieurs millisecondes lorsque le transistor est maintenu en mode linéaire.

A titre d'exemple, les inventeurs ont observé que l'évacuation d'une énergie de 1 Joule en 200 µs entraine une élévation de température du transistor allant jusqu'à 250°C alors que l'évacuation de la même énergie en 4 ms permet de maintenir la température du transistor en dessous de 50°C. Ainsi, ralentir l'évacuation de l'énergie stockée dans le stator 1 lors de la déconnexion des phases 12, 14, 16 par rapport à l'art antérieur permet de protéger le dispositif interrupteur 20 d'une élévation trop importante de sa température.

Dans l'exemple illustré en figure 2, le dispositif interrupteur 20 est situé entre la phase 14 et le dispositif de commande 30. Une borne du dispositif interrupteur 20 est connectée à une borne de la phase 14 ; l'autre borne du dispositif interrupteur 20 est connectée au dispositif de commande 30. Alternativement, le dispositif interrupteur 20 peut être situé entre la phase 14 et le neutre 18. Une borne du dispositif interrupteur 20 est alors connectée à une borne de la phase 14, l'autre borne étant connectée au neutre 18.

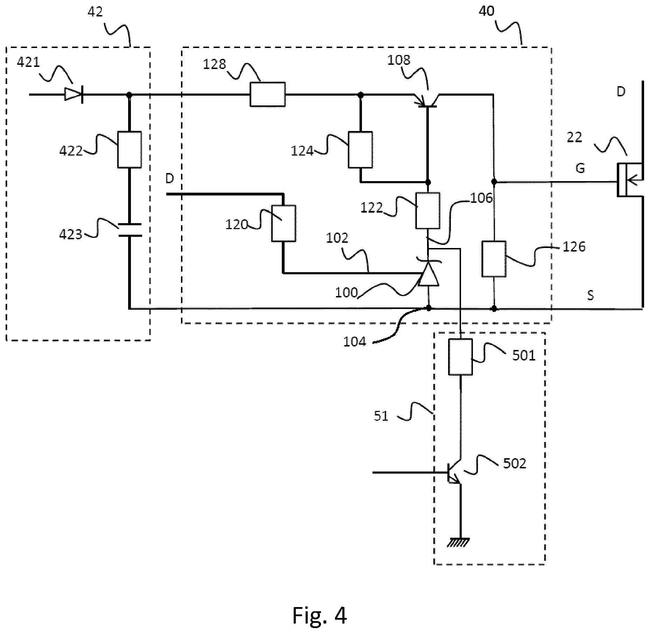

Selon un mode de réalisation de l'invention représenté à la figure 4, le circuit de contrôle 40 comprend un régulateur de tension 100. Le régulateur de tension 100 agit sur la tension entre sa cathode et son anode afin de maintenir la tension entre sa borne de référence et l'anode à une tension prédéterminée. De préférence, cette tension prédéterminée correspond à la tension de référence Vref décrite précédemment. La tension prédéterminée du régulateur de tension 100 est une donnée intrinsèque du régulateur, et est par exemple sensiblement égale à 2,5 Volts. Le régulateur de tension 100 peut être un régulateur de tension U16 de type TL431.

Avantageusement le régulateur de tension 100 assure l'asservissement en tension du transistor à effet de champ 22, le maintenant ainsi en mode linéaire.

Comme représenté sur la figure 4, la borne de référence 102 du régulateur de tension 100 est reliée au drain du transistor à effet de champ 22 via une résistance 120. La résistance 120 a typiquement une valeur comprise entre 1KΩ et 10KΩ.

L'anode 104 du régulateur de tension 100 est reliée à la source du transistor à effet de champ 22.

La cathode 106 du régulateur de tension 100 est reliée à la grille du transistor à effet de champ 22 via un transistor 108. Ce transistor 108 devient notamment passant lorsque la différence entre son potentiel de base et son potentiel d'émetteur est inférieur à un seuil, par exemple 0, 6V. Le transistor 108 est par exemple un transistor bipolaire, notamment de type PNP.

En particulier, la cathode 106 du régulateur de tension 100 est reliée à la base du transistor bipolaire 108 via une résistance 122. La résistance 122 a par exemple une valeur comprise entre 1KΩ et 10KΩ.

Une résistance 124 peut être montée entre la base du transistor bipolaire 108 et l'émetteur de dudit transistor bipolaire 108 afin de polariser le transistor bipolaire 108. La résistance 124 peut avoir une valeur comprise entre 500 Ω et 1500Ω, par exemple sensiblement égale à 1 kΩ.

Le collecteur du transistor bipolaire 108 est relié à la grille du transistor à effet de champ 22.

Une résistance 126 comprise notamment entre 40 kΩ et 60 kΩ, par exemple d'environ 47 kΩ, est montée entre la source et la grille du transistor à effet de champ 22 pour polariser le transistor à effet de champ 22.

L'émetteur du transistor bipolaire 108 est relié à l'alimentation électrique 42 via une résistance 128 d'une valeur comprise notamment entre 50 Ω et 150 Ω, par exemple autour de 100 Ω.

L'alimentation électrique comprend un circuit d'alimentation 42 également représenté sur la figure 4. Le circuit 42 est par exemple disposé entre la résistance 128 et l'anode 104 du régulateur de tension 100. Selon l'exemple représenté en figure 4, le circuit d'alimentation 42 comprend une diode 421 reliée d'une part à une source d'alimentation non représentée, par exemple la batterie du véhicule, et d'autre part à la résistance 128 ainsi qu'à une seconde résistance 422 montée en série avec une capacité 423.

Typiquement la résistance 422 est comprise entre 1 Ω et 100 Ω et la capacité 423 est comprise entre 100 nF et 10 µF.

La capacité 423 est par exemple également reliée à l'anode 104 du régulateur de tension 100. En fonctionnement normal, la tension à l'entrée du circuit d'alimentation 42 est par exemple de l'ordre de 12 Volts. Cette tension provient par exemple d'une batterie basse tension du véhicule. La capacité 423 est maintenue chargée par cette tension.

Lors de la déconnexion des phases moteurs, la tension à l'entrée du circuit d'alimentation 42 passe à 0 ou environ 0 volt, par exemple du fait que l'alimentation électrique issue de la batterie basse tension est interrompue. La capacité 423 alimente alors de façon autonome le dispositif d'évacuation d'énergie, en particulier le circuit de commande 40 et le dispositif interrupteur 20. La capacité 423 est avantageusement dimensionnée afin de permettre d'alimenter le circuit de contrôle 40 pendant une durée suffisante pour évacuer l'énergie stockée dans le stator 1 lors de la déconnexion des phases 12, 14, 16. En particulier, la capacité 423 alimente le circuit de commande 40 pendant une durée qui correspond au temps T2 pendant lequel le transistor 22 est maintenu en mode linéaire. Par exemple, la capacité 423 alimente le circuit de commande 40 pendant environ 5 ms après que la tension à l'entrée du circuit d'alimentation 42 passe à 0 Volt ou sensiblement 0Volts.

Lorsque la capacité 423 est déchargée, le circuit de commande 40 n'est plus alimenté ; le transistor à effet de champ 22 devient ouvert du fait qu'il ne reçoit plus de tension sur sa grille. Cependant, le transistor à effet de champ 22 n'entre pas en avalanche car l'énergie stockée dans le stator 1 a été évacuée.

Le dispositif peut également comprendre une unité de commande 51 également représentée en figure 4. Selon l'exemple représenté à la figure 4, l'unité de commande 51 est reliée à l'anode 104 du régulateur de tension 100. L'unité de commande 51 peut comprendre une résistance 501 entre l'anode 104 du régulateur de tension 100 et le collecteur d'un transistor 502. Ce transistor 502 devient notamment passant lorsque la différence entre son potentiel de base et son potentiel d'émetteur est supérieur à un seuil, par exemple 0, 6V. Le transistor 502 est par exemple un transistor bipolaire, notamment de type NPN. L'émetteur du transistor bipolaire 502 est relié à la masse et la base dudit transistor est connectée à un organe de commande, par exemple le dispositif de commande 30 du stator. L'état du transistor bipolaire 502 est alors commandé par le dispositif de commande 30.

En fonctionnement normal, le transistor bipolaire 502 est passant. Le régulateur de tension 100 est alors inhibé ; et le transistor bipolaire 108 est passant. Lors de la déconnexion des phases du moteur, le transistor bipolaire 502 est ouvert. Le régulateur de tension 100 est alors actif; l'état du transistor bipolaire 108 est commandé par la tension délivrée par le régulateur de tension 100.

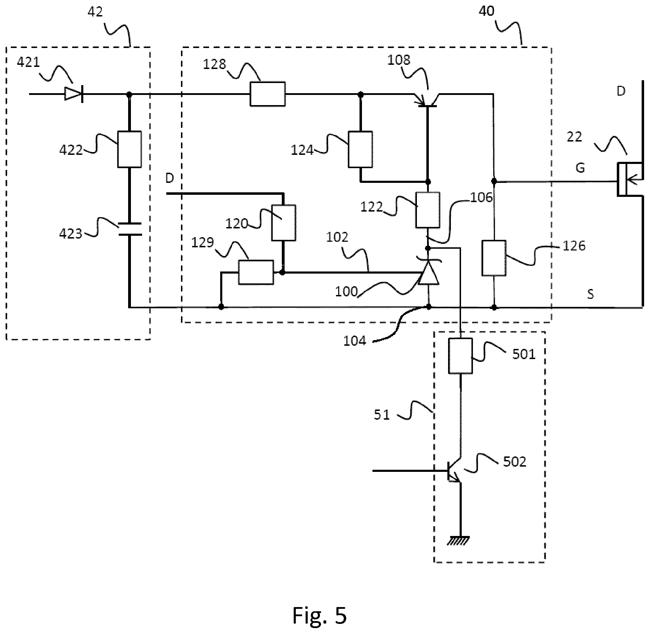

Selon un mode de réalisation représenté à la figure 5, une résistance 129 est ajoutée entre l'anode 104 et la borne de référence 102 du régulateur de tension 100 afin d'ajuster la valeur de la tension de référence Vref du régulateur de tension 100. Avantageusement, la résistance 129 ajoutée entre l'anode 104 et la borne de référence 102 est ajustable de sorte à pouvoir ajuster la tension de référence Vref du régulateur de tension.

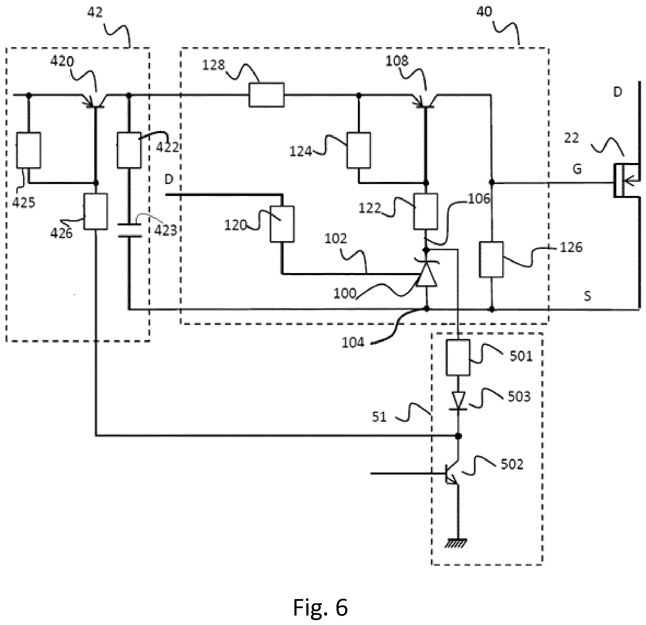

Selon un mode de réalisation illustré en figure 6, le circuit d'alimentation 42 peut comprendre un interrupteur, en particulier un transistor 420, à la place de la diode 421. Ce transistor 420 devient notamment passant lorsque la différence entre son potentiel de base et son potentiel d'émetteur est inférieur à un seuil, par exemple 0, 6V. Le transistor est par exemple un transistor bipolaire 420, notamment de type PNP. Le collecteur du transistor bipolaire 420 est notamment relié d'une part à une borne de la résistance 422 montée en série avec la capacité 423, et d'autre part avec la borne de la résistance 128 qui est opposée à celle reliée au transistor 108 du circuit de commande 40. L'émetteur du transistor bipolaire 420 est connecté à l'entrée du circuit d'alimentation 42. La base du transistor bipolaire 420 est reliée au collecteur du transistor 502 de l'unité de commande 51 par l'intermédiaire d'une résistance 426. Grâce aux résistances 425, 426 et au transistor 502, l'état du transistor 420 peut être contrôlé. En fonctionnement normal le transistor 420 est passant afin de charger la capacité 423 et de maintenir le dispositif interrupteur 20 passant. Lors de la déconnexion des phases moteurs 12, 14, 16 le transistor 420 du circuit d'alimentation 42 est ouvert. Ainsi, quelle que soit la tension délivrée en entrée du circuit d'alimentation 42, on s'assure que la déconnexion se fera de façon autonome grâce à la capacité 423. Pour faciliter la commande du transistor 420 circuit d'alimentation 42, l'unité de commande 51 peut comprendre une diode 503 montée en série entre la résistance 501 et le transistor 502. La cathode de la diode 503 est reliée au collecteur du transistor 502 ; l'anode de la diode 503 est reliée à une borne de la résistance 501.

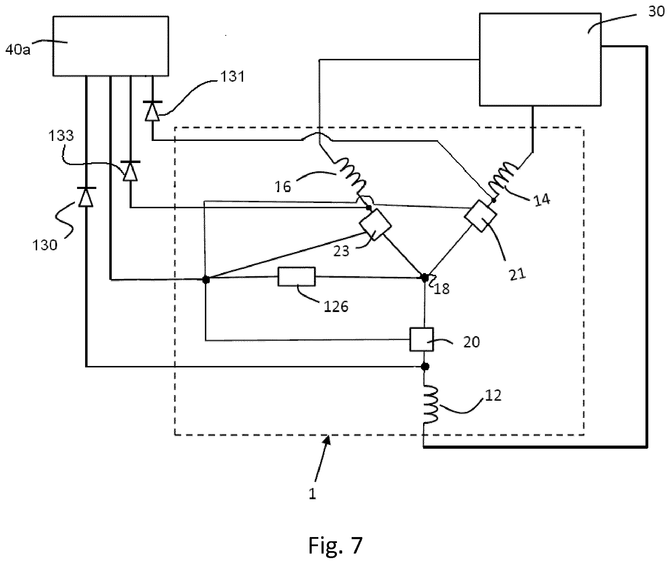

La figure 7 illustre un autre mode de réalisation du dispositif selon l'invention. Le stator 1 comprend trois phases électriques 12, 14, 16 connectées en étoile. Les phases sont en particulier définies par un enroulement électrique, par exemple au moyen de bobines électriques. Un dispositif interrupteur 20, 21, 23 est disposé entre chacune des trois phases électriques 12, 14, 16 et le neutre des phases.

Dans ce mode de réalisation, un seul circuit de commande 40 et/ou une seule alimentation électrique autonome 42 sont utilisés pour commander les dispositifs interrupteurs 20, 21, 23. Le circuit de commande 40 et l'alimentation autonome sont de préférence identiques à ceux illustrés en figures 4 à 6. Pour des raisons de clarté, l'alimentation électrique autonome n'est pas représentée sur la figure 7 ; l'impédance 126 du circuit de commande 40 est représentée ; les autres composants du circuit de commande 40 sont représentés dans un bloc 40a. Une seule impédance 126 est disposée entre la borne du dispositif interrupteur 20, 21, 23 qui n'est pas reliée à la phase 12, 14, 16, -cette borne est ici reliée au neutre 18 -, et l'électrode de commande de chacun des dispositifs interrupteurs 20, 21, 23. Une même impédance 126 est donc commune aux trois dispositifs interrupteurs 20, 21,23.

Avantageusement, cette configuration permet de limiter le nombre de composants et de fils entre le circuit de commande 40 et les dispositifs interrupteurs 20, 21, 23. En effet, un seul fil est nécessaire pour contrôler l'état d'ouverture des dispositifs interrupteurs 20, 21, 23. Un seul circuit de commande 40 permet de contrôler les états d'ouverture et de fermeture de l'ensemble des dispositifs interrupteurs 20, 21, 23.

Dans une variante, pour chaque dispositif interrupteur 20, 21, 23 une diode 130, 131, 133 respective est connectée entre une borne du dispositif interrupteur 20, 21, 23 et la résistance 120 reliée à la borne de référence 102 du régulateur de tension 100. En particulier, la diode 130, 131, 133 a son anode connectée à une borne du dispositif interrupteur, notamment au drain du transistor 22 ; et la diode a sa cathode connectée à la borne de la résistance 120 qui est différente de celle connectée à la borne de référence102 du régulateur de tension 100.

Dans l'exemple illustré en figure 7, les dispositifs interrupteurs 20, 21, 23 sont situés entre leur phase 12, 14, 16 respective et le neutre 18. Une borne du dispositif interrupteur 20, 21, 23 est connectée à une borne de la phase 12, 14, 16, l'autre borne étant connectée au neutre 18. Alternativement, les dispositifs interrupteurs 20, 21, 23 peuvent être situés entre la phase 12, 14, 16 et le dispositif de commande 30. Une borne du dispositif interrupteur 20, 21, 23 est alors connectée à une borne de la phase 12, 14, 16 ; l'autre borne du dispositif interrupteur 20, 21, 23 est connectée au dispositif de commande 30.

Le procédé selon l'invention peut s'appliquer à des configurations de phases en étoile comme représenté aux figures 2 et 7 ainsi qu'à des configurations de phases en triangle.

De manière plus générale, l'invention n'est pas limitée aux exemples décrits. Il est bien entendu que de nombreuses adaptations aux configurations décrites ci-dessus peuvent être introduites tout en conservant au moins certains des avantages de l'invention. Notamment, le mode de réalisation illustré en figure 6 peut comporter une résistance 129 ajoutée entre l'anode 104 et la borne de référence 102 du régulateur de tension 100, comme illustré en figure 5.

L'expression « comprenant un » doit être comprise comme synonyme de l'expression « comprenant au moins un », sauf lorsque le contraire est spécifié.

## Revendications

1. Procédé d'évacuation de l'énergie stockée dans un stator (1) d'un moteur électrique, notamment d'un moteur électrique de direction assistée d'un véhicule automobile, ledit stator (1) ayant au moins une phase électrique (12, 14, 16), un état de déconnexion de ladite phase (12, 14, 16) du stator (1) avec un dispositif de commande (30) étant contrôlé par un dispositif interrupteur (20, 21, 23) comprenant au moins un transistor à effet de champ (22),
le procédé comprenant une étape de
a) maintien du transistor à effet de champ (22) en mode linéaire lors de la déconnexion de ladite phase (12, 14, 16) en contrôlant la tension Vgs entre la grille (G) et la source (S) dudit transistor (22) de sorte à maintenir la tension Vds entre le drain (D) et la source (S) dudit transistor (22) sensiblement égale à une tension de référence Vref.

2. Procédé d'évacuation de l'énergie selon la revendication 1, dans lequel le moteur électrique est un moteur polyphasé, notamment un moteur triphasé, l'état de déconnexion des phases (12, 14, 16) étant contrôlé par des dispositifs interrupteurs (20, 21, 23) respectifs.

3. Procédé d'évacuation de l'énergie selon l'une des revendications 1 ou 2, dans lequel la tension de référence Vref est inférieure à la tension d'avalanche du transistor à effet de champ.

4. Procédé d'évacuation de l'énergie selon l'une des revendications précédentes, dans lequel le transistor à effet de champ (22) est maintenu en mode linéaire jusqu'à l'évacuation de l'énergie stockée dans le stator (1).

5. Procédé d'évacuation de l'énergie selon l'une des revendications précédentes, comprenant préalablement à l'étape de maintien a) du transistor à effet de champ (22) en mode linéaire, une étape a0) de réception d'un signal de déconnexion de phase initiant le procédé d'évacuation de l'énergie.

6. Procédé d'évacuation de l'énergie selon la revendication précédente, dans lequel l'étape de maintien a) succède immédiatement à l'étape a0) de réception d'un signal d'ouverture de phase.

7. Dispositif d'évacuation de l'énergie stockée dans un stator (1) d'un moteur électrique, notamment d'un moteur électrique de direction assistée d'un véhicule automobile, ledit stator (1) ayant au moins une phase électrique (12, 14, 16),
le dispositif d'évacuation comprenant :
- un dispositif interrupteur (20, 21, 23) destiné à contrôler un état de déconnexion de ladite phase (12, 14, 16) du stator (1) avec un dispositif de commande (30), ledit dispositif interrupteur (20, 21, 23) comprenant au moins un transistor à effet de champ (22),
- un circuit de commande (40) configuré pour maintenir le transistor à effet de champ (22) en mode linéaire lors de la déconnexion de ladite phase (12, 14, 16) en contrôlant la tension Vgs entre la grille (G) et la source (S) dudit transistor (22) de sorte à maintenir la tension Vds entre le drain (D) et la source (S) dudit transistor (22) sensiblement égale à une tension de référence Vref.

8. Dispositif d'évacuation de l'énergie selon la revendication 7, comprenant une alimentation électrique autonome (42) alimentant au moins le circuit de commande (40).

9. Dispositif d'évacuation de l'énergie selon la revendication 7 ou 8, dans lequel le circuit de commande (40) comprend un régulateur de tension (100) dont :
- la borne de référence est reliée au drain (D) dudit transistor à effet de champ (22),
- l'anode est reliée à la source (S) dudit transistor à effet de champ (22), et
- la cathode est reliée à la grille (G) du transistor à effet de champ (22).

10. Dispositif d'évacuation de l'énergie selon la revendication 9, dans lequel la cathode du régulateur de tension (100) est reliée à la grille (G) du transistor à effet de champ (22) via un transistor bipolaire (108), la base dudit transistor bipolaire étant reliée à la cathode du régulateur de tension (100), et le collecteur dudit transistor bipolaire (108) étant relié à la grille (G) dudit transistor à effet de champ (22).

11. Dispositif d'évacuation de l'énergie selon l'une des revendications 7 à 10, dans lequel le régulateur de tension (100) est de type TL431.

12. Dispositif d'évacuation de l'énergie selon l'une quelconque des revendications 7 à 11, comprenant un organe de réception d'un signal d'ouverture de phase.

## Patentansprüche

1. Verfahren zum Ableiten der in einem Stator (1) eines Elektromotors, insbesondere eines Elektromotors der Servolenkung eines Kraftfahrzeugs, gespeicherten Energie, wobei der Stator (1) mindestens eine elektrische Phase (12, 14, 16) hat, wobei ein Trennzustand der Phase (12, 14, 16) des Stators (1) von einer Steuervorrichtung (30) durch eine Schaltervorrichtung (20, 21, 23) kontrolliert wird, die mindestens einen Feldeffekttransistor (22) umfasst, wobei das Verfahren ein Schritt umfasst des
a) Haltens des Feldeffekttransistors (22) im Linearbetrieb bei der Trennung der Phase (12, 14, 16), indem die Spannung Vgs zwischen dem Gate (G) und der Source (S) des Transistors (22) kontrolliert wird, so dass die Spannung Vds zwischen dem Drain (D) und der Source (S) des Transistors (22) im Wesentlichen gleich einer Bezugsspannung Vref ist.

2. Verfahren zum Ableiten der Energie nach Anspruch 1, bei dem der Elektromotor ein Mehrphasenmotor, insbesondere ein Dreiphasenmotor, ist, wobei der Trennzustand der Phasen (12, 14, 16) von jeweiligen Schaltervorrichtungen (20, 21, 23) kontrolliert wird.

3. Verfahren zum Ableiten der Energie nach einem der Ansprüche 1 oder 2, bei dem die Bezugsspannung Vref geringer als die Durchbruchspannung des Feldeffekttransistors ist.

4. Verfahren zum Ableiten der Energie nach einem der vorhergehenden Ansprüche, bei dem der Feldeffekttransistor (22) bis zur Ableitung der im Stator (1) gespeicherten Energie im Linearbetrieb gehalten wird.

5. Verfahren zum Ableiten der Energie nach einem der vorhergehenden Ansprüche, umfassend vor dem Schritt a) des Haltens des Feldeffekttransistors (22) im Linearbetrieb einen Schritt a0) des Empfangens eines Phasentrennsignals, welches das Verfahren zum Ableiten der Energie einleitet.

6. Verfahren zum Ableiten der Energie nach dem vorhergehenden Anspruch, bei dem der Schritt a) des Haltens unmittelbar auf den Schritt a0) des Empfangens eines Phasenöffnungssignals folgt.

7. Vorrichtung zum Ableiten der in einem Stator (1) eines Elektromotors, insbesondere eines Elektromotors der Servolenkung eines Kraftfahrzeugs, gespeicherten Energie, wobei der Stator (1) mindestens eine elektrische Phase (12, 14, 16) hat,
wobei die Vorrichtung zum Ableiten umfasst:
- eine Schaltervorrichtung (20, 21, 23), die dazu bestimmt ist, einen Trennzustand der Phase (12, 14, 16) des Stators (1) von einer Steuervorrichtung (30) zu kontrollieren, wobei die Schaltervorrichtung (20, 21, 23) mindestens einen Feldeffekttransistor (22) umfasst,
- eine Steuerschaltung (40), die dazu ausgebildet ist, den Feldeffekttransistors (22) beim Trennen der Phase (12, 14, 16) im Linearbetrieb zu halten, indem sie die Spannung Vgs zwischen dem Gate (G) und der Source (S) des Transistors (22) kontrolliert, so dass die Spannung Vds zwischen dem Drain (D) und der Source (S) des Transistors (22) im Wesentlichen gleich einer Bezugsspannung Vref ist.

8. Vorrichtung zum Ableiten der Energie nach Anspruch 7, umfassend eine autonome Stromversorgung (42), die mindestens die Steuerschaltung (40) versorgt.

9. Vorrichtung zum Ableiten der Energie nach Anspruch 7 oder 8, bei der die Steuerschaltung (40) einen Spannungsregler (100) umfasst, dessen:
- Bezugsklemme mit dem Drain (D) des Feldeffekttransistors (22) verbunden ist,
- Anode mit der Source (S) des Feldeffekttransistors (22) verbunden ist und dessen
- Kathode mit dem Gate (G) des Feldeffekttransistors (22) verbunden ist.

10. Vorrichtung zum Ableiten der Energie nach Anspruch 9, bei der die Kathode des Spannungsreglers (100) mit dem Gate (G) des Feldeffekttransistors (22) über einen bipolaren Transistor (108) verbunden ist, wobei die Basis des bipolaren Transistors mit der Kathode des Spannungsreglers (100) verbunden ist und der Kollektor des bipolaren Transistors (108) mit dem Gate (G) des Feldeffekttransistors (22) verbunden ist.

11. Vorrichtung zum Ableiten der Energie nach einem der Ansprüche 7 bis 10, bei welcher der Spannungsregler (100) vom Typ TL431 ist.

12. Vorrichtung zum Ableiten der Energie nach einem der Ansprüche 7 bis 11, umfassend ein Element zum Empfangen eines Phasenöffnungssignals.

## Claims

1. Method for discharging energy stored in a stator (1) of an electric motor, notably of an assisted steering electric motor of a motor vehicle, said stator (1) having at least one electrical phase (12, 14, 16), a state of disconnection of said phase (12, 14, 16) of the stator (1) with a control device (30) being controlled by a switch device (20, 21, 23) comprising at least one field effect transistor (22),
the method comprising a step of
a) keeping the field effect transistor (22) in linear mode during the disconnection of said phase (12, 14, 16) by controlling the voltage Vgs between the gate (G) and the source (S) of said transistor (22) so as to keep the voltage Vds between the drain (D) and the source (S) of said transistor (22) substantially equal to a reference voltage Vref.

2. Method for discharging energy according to Claim 1, in which the electric motor is a polyphase motor, notably a three-phase motor, the state of disconnection of the phases (12, 14, 16) being controlled by respective switch devices (20, 21, 23).

3. Method for discharging energy according to one of Claims 1 or 2, in which the reference voltage Vref is lower than the avalanche voltage of the field effect transistor.

4. Method for discharging energy according to one of the preceding claims, in which the field effect transistor (22) is kept in linear mode until the energy stored in the stator (1) is discharged.

5. Method for discharging energy according to one of the preceding claims, comprising, prior to the step a) of keeping the field effect transistor (22) in linear mode, a step a0) of reception of a phase disconnection signal initiating the energy discharging method.

6. Method for discharging energy according to the preceding claim, in which the keeping step a) immediately succeeds the step a0) of reception of a phase opening signal.

7. Device for discharging energy stored in a stator (1) of an electric motor, notably of an assisted steering electric motor of a motor vehicle, said stator (1) having at least one electrical phase (12, 14, 16), the discharging device comprising:
- a switch device (20, 21, 23) intended to control a state of disconnection of said phase (12, 14, 16) of the stator (1) with a control device (30), said switch device (20, 21, 23) comprising at least one field effect transistor (22),
- a control circuit (40) configured to keep the field effect transistor (22) in linear mode during the disconnection of said phase (12, 14, 16) by controlling the voltage Vgs between the gate (G) and the source (S) of said transistor (22) so as to keep the voltage Vds between the drain (D) and the source (S) of said transistor (22) substantially equal to a reference voltage Vref.

8. Energy discharging device according to Claim 7, comprising a standalone electrical power supply (42) powering at least the control circuit (40).

9. Energy discharging device according to Claim 7 or 8, in which the control circuit (40) comprises a voltage regulator (100) of which:
- the reference terminal is linked to the drain (D) of said field effect transistor (22),
- the anode is linked to the source (S) of said field effect transistor (22), and
- the cathode is linked to the gate (G) of the field effect transistor (22).

10. Energy discharging device according to Claim 9, in which the cathode of the voltage regulator (100) is linked to the gate (G) of the field effect transistor (22) via a bipolar transistor (108), the base of said bipolar transistor being linked to the cathode of the voltage regulator (100), and the collector of said bipolar transistor (108) being linked to the gate (G) of said field effect transistor (22).

11. Energy discharging device according to one of Claims 7 to 10, in which the voltage regulator (100) is of TL431 type.

12. Energy discharging device according to any one of Claims 7 to 11, comprising a member for receiving a phase opening signal.
